# EUROPÄISCHE PATENTSCHRIFT

(11) **EP 2 566 308 B1**
(45) Veröffentlichungstag und Bekanntmachung des Hinweises auf die Patenterteilung: **02.01.2019**
(21) Anmeldenummer: 12006171.8
(22) Anmeldetag: 30.08.2012
(51) Int. Cl.: H05K 1/02, H05K 3/00, H01L 25/00, H01L 23/36, H01L 23/367, H01L 25/065

(54) **Verfahren zur Bestückung einer Leiterplatte**
Method for filling a circuit board
Procédé d'équipement d'une plaquette

(30) Priorität: 04.09.2011 DE 102011112090
(43) Veröffentlichungstag der Anmeldung: 06.03.2013
(73) Patentinhaber: Schoeller-Electronics GmbH, 35083 Wetter / Hessen (DE)
(72) Erfinder: Berkel, Jan Hendrik, 7462 BR Rijssen (NL)
(74) Vertreter: Gottschald, Jan

(56) Entgegenhaltungen:
- EP-A2- 0 124 029
- EP-A2- 1 503 615
- WO-A1-2012/076166
- DE-A1- 10 014 458

## Beschreibung

Die Erfindung betrifft ein Verfahren zur Bestückung einer Leiterplatte gemäß Anspruch 1 und eine Leiterplatte gemäß Anspruch 6.

Eine Leiterplatte besteht heute regelmäßig aus mehreren insbesondere starren Lagen von glasfaserverstärkten, ausgehärteten Epoxidharz-Platten, die ein- oder beidseitig kupferkaschiert oder mit Leiterbahnen versehen sind. Die Leiterplatte ist bestückt mit Halbleiter-Bauteilen, mit Anschlusselementen, mit Elementen zur Wärmeableitung o. dgl.. In diesem Sinne ist der Begriff "Bestückung" vorliegend weit auszulegen.

Es ist bekannt, Leiterplatten mit diskreten Halbleiterbauteilen zu bestücken, die ein Gehäuse mit Kontaktpins aufweisen. In dem Gehäuse befindet sich mindestens ein Halbleiter-Nacktchip (Halbleiter-Die), der mit den Kontaktpins elektrisch verbunden, beispielsweise gebondet ist.

Im Zuge der immer steigenden Miniaturisierung bei der Auslegung von Leiterplatten ist es auch bekannt geworden, in einem Applikationsschritt einen Halbleiter-Nacktchip ohne Gehäuse direkt auf die Leiterplatte zu applizieren. Ein solcher Halbleiter-Nacktchip wird als "Bare Die" bezeichnet. Bei dieser Direktmontage folgt dem Applikationsschritt meist ein Bondingschritt, in dem der Halbleiter-Nacktchip elektrisch mit der Leiterplatte kontaktiert wird.

Bei dem bekannten Verfahren (US 6,809,935 B1, dort Fig. 1) wird ein Halbleiter-Nacktchip unmittelbar auf die metallische Grundplatte einer Leiterplatte aufgebracht, die eine flächige Wärmesenke für die Leiterplatte bereitstellt. Damit ist zwar eine gute Ableitung der von dem Halbleiter-Bauteil erzeugten Wärme sichergestellt. Allerdings ist problematisch, dass die Wärmeausdehnungskoeffizienten der Grundplatte und des Halbleiter-Nacktchips zueinander unterschiedlich sind, was durch eine zwischen Grundplatte und Halbleiter-Nacktchip angeordneter Kleberschicht ausgeglichen werden muss. Dies führt langfristig zu einer ungewünschten temperaturbedingten mechanischen Belastung des Halbleiter-Nacktchips.

EP0124029 offenbart den Oberbegriff der Ansprüche 1 und 6.

Der Erfindung liegt das Problem zu Grunde, das bekannte Verfahren zur Bestückung einer Leiterplatte derart weiterzubilden, dass eine optimale Wärmeableitung bei geringer temperaturbedingter mechanischer Belastung des Halbleiter-Nacktchips möglich ist.

Das obige Problem wird durch ein Verfahren gemäß Anspruch 1 gelöst.

Wesentlich ist die grundsätzliche Überlegung, die Leiterplatte oder ein Leiterplatten-Halbfertigteil zunächst mit mindestens einem Flanscheinsatz auszustatten und erst anschließend mindestens einen Halbleiter-Nacktchip auf den eingesetzten Flanscheinsatz zu applizieren.

Im Einzelnen wird vorgeschlagen, dass in einem Montageschritt mindestens ein starrer Flanscheinsatz in eine zugeordnete Aussparung in der Leiterplatte oder in einem Leiterplatten-Halbfertigteil eingesetzt wird und dass in einem nachfolgenden Applikationsschritt auf den bereits eingesetzten Flanscheinsatz mindestens ein Halbleiter-Nacktchip eines Halbleiter-Bauteils appliziert wird.

Dies kann natürlich für eine beliebige Anzahl von Flanscheinsätzen und Halbleiter-Nacktchips vorgesehen sein. Zur besseren Übersichtlichkeit ist im Folgenden allerdings fast durchweg die Rede von nur einem Flanscheinsatz und einem Halbleiter-Nacktchip. Diese Ausführungen gelten dann für alle weiteren Flanscheinsätze und Halbleiter-Nacktchips entsprechend.

Dadurch, dass der Halbleiter-Nacktchip nunmehr auf einem Einsatz, nämlich dem Flanscheinsatz, appliziert wird, kann durch Auswahl eines geeigneten Einsatzes eine optimale Kontaktstruktur zwischen Flanscheinsatz und Halbleiter-Nacktchip hergestellt werden. Im Einzelnen lässt sich der Flanscheinsatz hinsichtlich seiner Materialeigenschaften optimal auf die Materialeigenschaften des Halbleiter-Nacktchips anpassen. Dies betrifft insbesondere eine Anpassung im Hinblick auf die Wärmeausdehnungskoeffizienten von Flanscheinsatz und Halbleiter-Nacktchip.

Im Sinne einer einfachen Durchführbarkeit des Montageschritts ist es für die vorschlagsgemäße Lösung von Bedeutung, dass der starre Flanscheinsatz als solcher einsetzbar ist. Bei dem Flanscheinsatz handelt es sich also nicht etwa um eine Beschichtung o. dgl..

Wie oben angedeutet, kann der Flanscheinsatz auch in eine zugeordnete Aussparung in einem Leiterplatten-Halbfertigteil eingesetzt werden. Bei diesem Leiterplatten-Halbfertigteil kann es sich beispielsweise um eine Grundplatte der Leiterplatte aus Kupfer o. dgl. handeln, die in noch zu erläuternder Weise Bestandteil einer Wärmesenke ist. In besonders bevorzugter Ausgestaltung wird das Leiterplatten-Halbfertigteil erst nach dem Montageschritt und vor dem Applikationsschritt mit der Leiterplatte im Übrigen verbunden. Die Bestückung der Leiterplatte im obigen Sinne greift somit in den Herstellungsprozeß der Leiterplatte ein.

Bei der erfindungsgemäßen Ausgestaltung ist der Flanscheinsatz einer Wärmesenke der Leiterplatte zugeordnet, wobei der Flanscheinsatz mit einem flanschseitigen Wärmeleitabschnitt der Wärmesenke in wärmeleitendem Kontakt gebracht wird. Durch die Einsetzbarkeit des Flanscheinsatzes lässt sich der Flanscheinsatz auf einen optimalen Kompromiss zwischen guter Wärmeleitung und geringer temperaturbedingter mechanischer Belastung des Halbleiter-Nacktchips auslegen.

Die obige Auslegung des Flanscheinsatzes führt gemäß Anspruch 3 vorzugsweise dazu, dass der Wärmeausdehnungskoeffizient des Flanscheinsatzes unterschiedlich zu dem Wärmeausdehnungskoeffizienten des flanschseitigen Wärmeleitabschnitts ist.

Bei der besonders bevorzugten Ausgestaltung gemäß Anspruch 4 kommt der Wärmeausdehnungskoeffizient des Flanscheinsatzes dem Wärmeausdehnungskoeffizienten des Halbleiter-Nacktchips sehr nahe, was grundsätzlich zu einer Reduzierung von temperaturbedingten mechanischen Belastungen des Halbleiter-Nacktchips führt.

Grundsätzlich können der Flanscheinsatz und der flanschseitige Wärmeleitabschnitt in die jeweilige Aussparung eingeklebt, eingelötet o. dgl. sein. Gemäß Anspruch 5 ist es allerdings vorgesehen, dass das Einsetzen jeweils auf ein Einpressen zur Erzeugung eines Presssitzes zurückgeht. Damit kann auf zusätzliche Befestigungsmaßnahmen für den Flanscheinsatz und/oder den flanschseitigen Wärmeleitabschnitt verzichtet werden.

Nach einer weiteren Lehre gemäß Anspruch 6, der eigenständige Bedeutung zukommt, wird eine Leiterplatte mit mindestens einer ein- oder beidseitig kupferkaschierten oder mit Leiterbahnen versehenen, vorzugsweise starren Lage und mit einer Wärmesenke für die Ableitung der von mindestens einem Halbleiter-Bauteil erzeugten Wärme beansprucht.

Wesentlich nach der weiteren Lehre ist die Überlegung, dass die Wärmesenke eine Aussparung für einen starren Flanscheinsatz aufweist, auf den in obiger Weise ein Halbleiter-Nacktchip applizierbar ist, wobei der Wärmeausdehnungskoeffizient des Flanscheinsatzes unterschiedlich zu dem Wärmeausdehnungskoeffizienten des flanschseitigen Wärmeleitabschnitts ist.

Durch die vorschlagsgemäße Mehrteiligkeit der Wärmesenke, insbesondere durch die Einsetzbarkeit des Flanscheinsatzes, lässt sich wie oben erläutert eine optimale Anpassung des Flanscheinsatzes auf den jeweiligen Halbleiter-Nacktchip erzeugen.

Im Folgenden wird die Erfindung anhand einer lediglich Ausführungsbeispiele darstellenden Zeichnung erläutert. In der Zeichnung zeigt
- Fig. 1: einen Abschnitt einer vorschlagsgemäßen Leiterplatte im Querschnitt,
- Fig. 2: einen Abschnitt der Leiterplatte gemäß Fig. 1 in einer perspektivischen Explosionsdarstellung,
- Fig. 3: eine vorschlagsgemäße Leiterplatte im Querschnitt in einer weiteren Ausführungsform und
- Fig.4: eine vorschlagsgemäße Leiterplatte im Querschnitt in einer weiteren Ausführungsform.

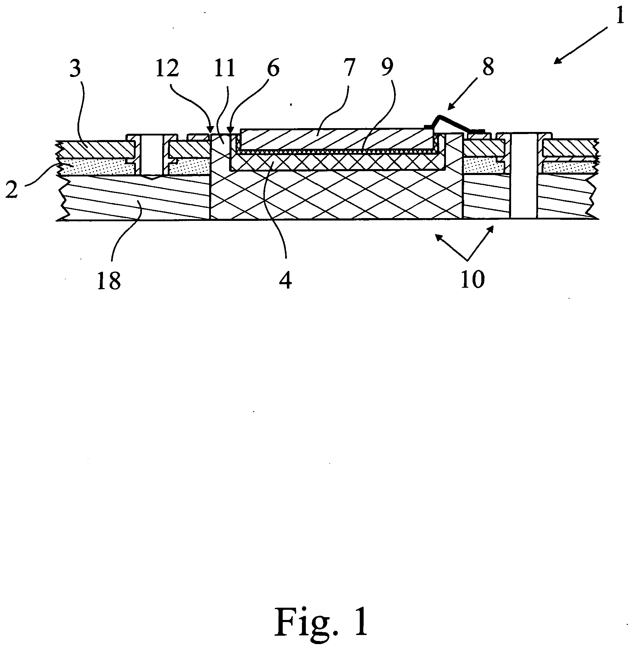

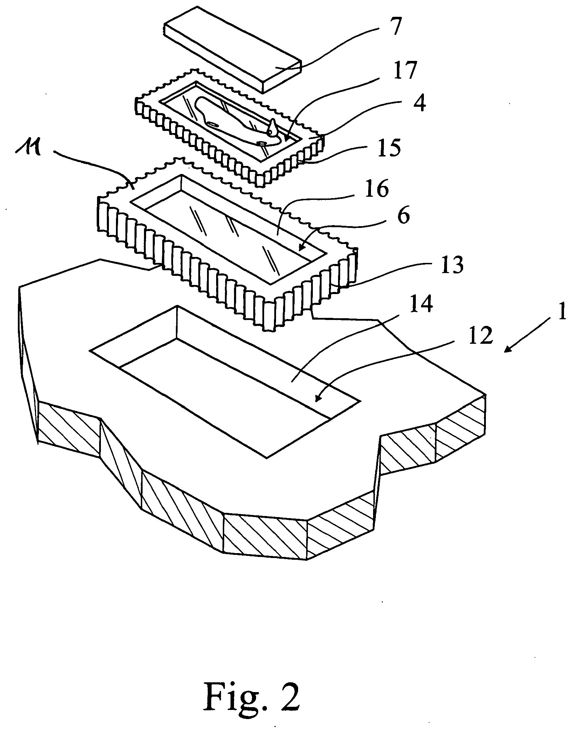

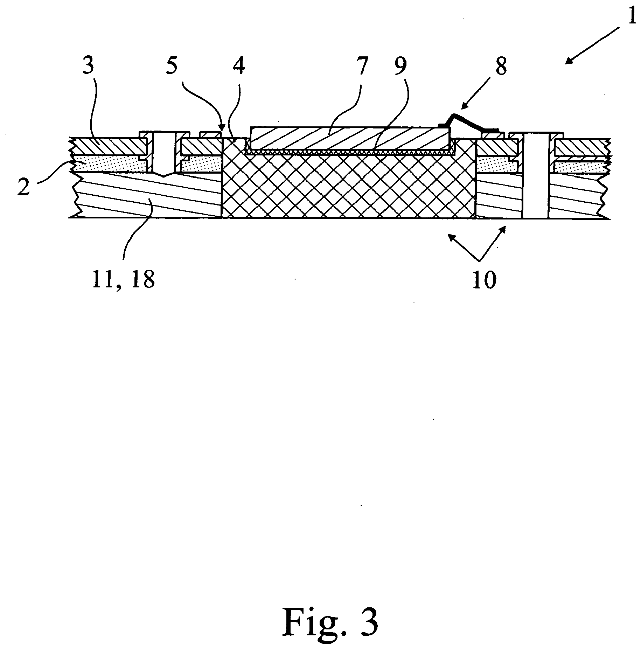

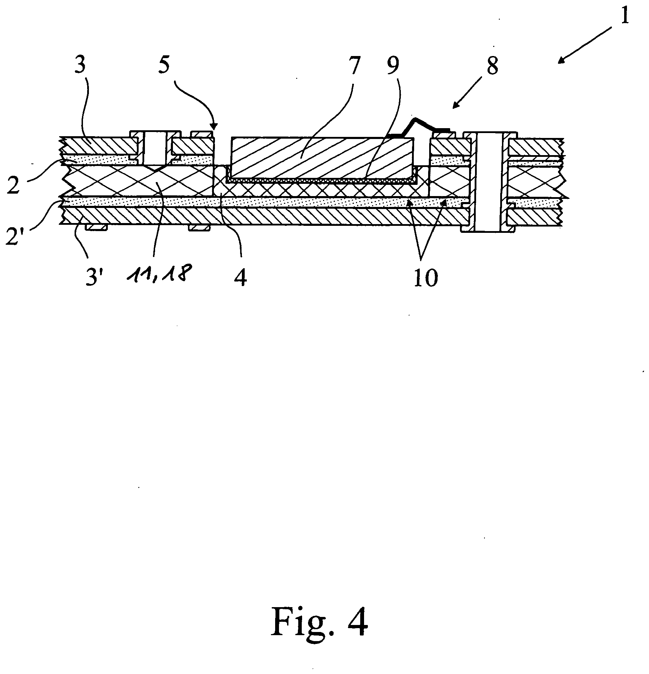

Das vorschlagsgemäße Verfahren dient der Bestückung einer Leiterplatte 1, die in drei Ausführungsformen in den Fig. 1 und 2, in Fig. 3 und in Fig. 4 gezeigt ist. Die Leiterplatte 1 kann weitgehend beliebig ausgestaltet sein, wobei mindestens eine ein- oder beidseitig kupferkaschierte oder mit Leiterbahnen versehene, vorzugsweise starre Lage 2 vorgesehen ist. Grundsätzlich kann die Leiterplatte 1 auch teilweise oder sogar komplett flexibel ausgestaltet sein. In den dargestellten Ausführungsbeispielen ist die Leiterplatte 1 auf der Oberseite mit einer Kupferschicht 3 versehen, was ebenfalls nicht beschränkend zu verstehen ist.

Die Fig. 1, 3 und 4 zeigen die jeweilige Leiterplatte 1 im bestückten Zustand. Zu erkennen ist ein starrer Flanscheinsatz 4, der in eine zugeordnete Aussparung 5 in der Leiterplatte 1 oder in eine zugeordnete Aussparung 6 in einem der Leiterplatte 1 zugeordneten, noch zu erläuternden Leiterplatten-Halbfertigteil 11, 18 eingesetzt ist. Der Flanscheinsatz 4 kann ein- oder mehrteilig ausgestaltet sein. Auf den Flanscheinsatz 4 ist ein Halbleiter-Nacktchip 7 eines Halbleiter-Bauteils 8 appliziert.

Wesentlich für das vorschlagsgemäße Verfahren ist, dass zunächst einmal in einem Montageschritt der starre Flanscheinsatz 4 eingesetzt wird und dass erst in einem nachfolgenden Applikationsschritt auf den eingesetzten Flanscheinsatz 4 ein Halbleiter-Nacktchip 7 eines Halbleiter-Bauteils 8 appliziert wird.

An den Applikationsschritt schließt sich ein Bondingschritt an, in dem der Halbleiter-Nacktchip 7 elektrisch kontaktiert wird. Der Bondingschritt ist für die vorschlagsgemäße Lösung nicht weiter von Bedeutung und wird daher nicht weiter erläutert.

Zur Klarstellung darf darauf hingewiesen werden, dass mit dem Begriff "Halbleiter-Bauteil" das funktionsfähige Bauteil gemeint ist, das sich aus dem applizierten und gebondeten Halbleiter-Nacktchip 7 ergibt.

Die Applikation des Halbleiter-Nacktchips 7 auf den Flanscheinsatz 4 erfolgt vorzugsweise mittels einer Kleberschicht 9, für deren Realisierung zahlreiche Möglichkeiten aus dem Stand der Technik bekannt sind.

Für den Fall, dass im Montageschritt der Flanscheinsatz 4 in eine zugeordnete Aussparung in einem Leiterplatten-Halbfertigteil 11, 18 eingesetzt werden soll, ist es vorzugsweise vorgesehen, dass das Leiterplatten-Halbfertigteil 11, 18 nach dem Montageschritt und vor dem Applikationsschritt mit der Leiterplatte 1 im Übrigen verbunden wird. Mit "Leiterplatten-Halbfertigteil" ist irgendein Teil der Leiterplatte 1 gemeint, das noch mit der Leiterplatte 1 im Übrigen zu verbinden ist. Dabei kann es sich beispielsweise um einen noch zu erläuternden, flanschseitigen Wärmeleitabschnitt 11, der ggf. selbst in ein Leiterplatten-Halbfertigteil einsetzbar ist, oder um eine ebenfalls noch zu erläuternde Grundplatte 18 der Leiterplatte 1 handeln.

Bei beiden in der Zeichnung dargestellten Ausführungsbeispielen ist der Flanscheinsatz 4 einer Wärmesenke 10 der Leiterplatte 1 zugeordnet, wobei der Flanscheinsatz 4 mit einem flanschseitigen Wärmeleitabschnitt 11 in wärmeleitendem Kontakt steht. Dabei kann der flanschseitige Wärmeleitabschnitt 11 selbst als starrer Einsatz ausgestaltet sein, wie im Folgenden beschrieben ist.

Bei der in Fig. 1 dargestellten Ausgestaltung ergeben sich zwei bevorzugte Bestückungsvarianten.

In einer ersten Bestückungsvariante wird noch vor dem Montageschritt der flanschseitige Wärmeleitabschnitt 11 der Wärmesenke 10 in eine Aussparung 12 in der Leiterplatte 1 eingesetzt, wobei im anschließenden Montageschritt der Flanscheinsatz 4 in eine Aussparung 6 in dem Wärmeleitabschnitt 11 eingesetzt wird. Bei einer anderen bevorzugten Verfahrensvariante wird der Flanscheinsatz 4 im Montageschritt in eine Aussparung 6 in dem flanschseitigen Wärmeleitabschnitt 11 der Wärmesenke 10 eingesetzt, wobei danach der flanschseitige Wärmeleitabschnitt 11 zusammen mit dem Flanscheinsatz 4 in die zugeordnete Aussparung 12 in der Leiterplatte 1 eingesetzt wird. In einer bevorzugten Variante ist es vorgesehen, dass nach dem Montageschritt und vor dem Einsetzen des flanschseitigen Wärmeleitabschnitts 11 zusammen mit dem Flanscheinsatz 4 in die zugeordnete Aussparung 12 in der Leiterplatte 1 der Applikationsschritt vollzogen wird.

Zur Klarstellung darf darauf hingewiesen werden, dass sich die beiden oben beschriebenen Bestückungsvarianten grundsätzlich auch auf ein Leiterplatten-Halbfertigteil, das noch mit der Leiterplatte 1 im Übrigen zu verbinden ist, anwenden lassen.

Von besonderer Bedeutung ist die Materialauslegung des Flanscheinsatzes 4. Im Vordergrund steht hier, dass der Wärmeausdehnungskoeffizient des Flanscheinsatzes 4 unterschiedlich zu dem Wärmeausdehnungskoeffizienten des flanschseitigen Wärmeleitabschnitts 11 ist, so dass eine entsprechende Anpassung an den Halbleiter-Nacktchip 7 möglich ist. Durch diese Anpassung ergibt sich regelmäßig, dass der Wärmeausdehnungskoeffizient des Flanscheinsatzes 4 kleiner als der Wärmeausdehnungskoeffizient des flanschseitigen Wärmeleitabschnitts 11 ist. Vorzugsweise ist es so, dass der Wärmeausdehnungskoeffizient des Flanscheinsatzes 4 weniger als 90%, insbesondere weniger als 80%, des Wärmeausdehnungskoeffizienten des flanschseitigen Wärmeleitabschnitts 11 beträgt. Die temperaturbedingte Ausdehnung des Flanscheinsatzes 4 ist also geringer als die temperaturbedingte Ausdehnung des flanschseitigen Wärmeleitabschnitts 11.

Der Begriff "Wärmeausdehnungskoeffizient" betrifft hier genau die Wärmeausdehnung, die eine temperaturbasierte mechanische Belastung zwischen Flanscheinsatz 4 und Halbleiter-Nacktchip 7 erzeugen kann. Bei einem flächigen Aufliegen des Halbleiter-Nacktchips 7 auf dem Flanscheinsatz 4 betrifft der Wärmeausdehnungskoeffizient entsprechend die Wärmeausdehnung entlang der Kontaktfläche zwischen Flanscheinsatz 4 und Halbleiter-Nacktchip 7.

In besonders bevorzugter Ausgestaltung ist der Wärmeausdehnungskoeffizient des Flanscheinsatzes 4 auf den Wärmeausdehnungskoeffizienten des applizierten Halbleiter-Nacktchips 7 hin ausgelegt. Vorzugsweise weist der Flanscheinsatz 4 dann einen Wärmeausdehnungskoeffizienten auf, dessen Abweichung vom Wärmeausdehnungskoeffizienten des applizierten Halbleiter-Nacktchips 7 weniger als 10 %, vorzugsweise weniger als 5 %, weiter vorzugsweise weniger als 2 %, beträgt.

Grundsätzlich kann der Flanscheinsatz 4 in die jeweilige Aussparung 5, 6 eingeklebt, eingelötet o. dgl. sein. Das gleiche gilt für die Befestigung des flanschseitigen Wärmeleitabschnitts 11 in der der zugeordneten Aussparung 12. Hier und vorzugsweise ist es allerdings so, dass das Einsetzen des Flanscheinsatzes 4 zur Erzeugung eines Presssitzes auf ein Einpressen des Flanscheinsatzes 4 in die jeweilige Aussparung 5, 6 zurückgeht. Alternativ oder zusätzlich kann es vorgesehen sein, dass der flanschseitige Wärmeleitabschnitt 11 zur Erzeugung eines Presssitzes in die zugeordnete Aussparung 12 eingepresst wird.

Beim Einpressen des Flanscheinsatzes 4 bzw. des flanschseitigen Wärmeleitabschnitts 11 entsteht vorzugsweise eine Mischung aus einem Kraftschluss und einem Formschluss, die im Ergebnis einen festen Sitz des Flanscheinsatzes 4 bzw. des flanschseitigen Wärmeleitabschnitts 11 gewährleistet.

Grundsätzlich sind auch andere Arten der Befestigung des Flanscheinsatzes 4 bzw. des flanschseitigen Wärmeleitabschnitts 11 denkbar. Wesentlich bei allen Varianten der Befestigung des Flanscheinsatzes 4 bzw. des flanschseitigen Wärmeleitabschnitts 11 ist, dass sich eine Wärmeausdehnung des flanschseitigen Wärmeleitabschnitts 11 nicht oder nur in geringem Maße mechanisch auf den Halbleiter-Nacktchip 7 überträgt.

Bei der Erzeugung eines Presssitzes für den Flanscheinsatz 4 bzw. für den flanschseitigen Wärmeleitabschnitt 11 ist die mechanische Stabilität der betreffenden Komponenten von besonderer Bedeutung, wobei gleichzeitig eine gute Wärmeleitfähigkeit und, soweit der Flanscheinsatz 4 betroffen ist, ein angepasster Wärmeausdehnungskoeffizient nicht außer Acht gelassen werden dürfen. Es hat sich gezeigt, dass gute Ergebnisse dadurch erzielbar sind, dass der flanschseitige Wärmeleitabschnitt 11 der Wärmesenke 10 und/oder der Flanscheinsatz 4 aus einem metallischen Material besteht bzw. bestehen. Für den flanschseitigen Wärmeleitabschnitt 10 bietet sich hier insbesondere kostengünstiges Kupfer an.

Bei dem dargestellten und insoweit bevorzugten Ausführungsbeispiel sind der Flanscheinsatz 4 und der flanschseitige Wärmeleitabschnitt 11 jeweils einstückig ausgebildet. Dies ist wiederum im Hinblick auf die oben angesprochene Erzeugung eines Presssitzes vorteilhaft.

Zur Klarstellung darf darauf hingewiesen werden, dass der Begriff "Aussparung" als Durchbruch oder als wannenförmige Ausnehmung verstanden werden kann. Dies betrifft sowohl die Aussparungen 5, 12 in der Leiterplatte 1 als auch die Aussparung 6 in dem flanschseitigen Wärmeleitabschnitt 11.

Für die Ausgestaltung des flanschseitigen Wärmeleitabschnitts 11 sind zahlreiche konstruktive Varianten denkbar. Hier und vorzugsweise ist der flanschseitige Wärmeleitabschnitt 11 im Wesentlichen plattenartig ausgestaltet. Dabei ist die Aussparung 6 in dem Wärmeleitabschnitt 11 im Wesentlichen wannenartig ausgebildet. Dies lässt sich der Darstellung gemäß Fig. 2 entnehmen.

Der Darstellung gemäß Fig. 2 lässt sich auch entnehmen, dass der flanschseitige Wärmeleitabschnitt 11 eine im Wesentlichen gezackte Außenkontur 13 aufweist, während die zugeordnete Aussparung 12 in der Leiterplatte 1 eine im Wesentlichen glatte Innenkontur 14 aufweist. Denkbar ist aber auch, dass die Aussparung 12 eine ebenfalls im Wesentlichen gezackte Innenkontur 14 aufweist. Anstelle der gezackten Konturen können sowohl bei der Außenkontur 13 als auch bei der Innenkontur 14 auch gewellte Konturen Anwendung finden.

Der flanschseitige Wärmeleitabschnitt 11 entspricht im Wesentlichen den bekannten plattenartigen Wärmeleitabschnitten, die auch als Press-Fit-Coin bekannt geworden sind.

Hier und vorzugsweise ist auch der Flanscheinsatz 4 im Wesentlichen plattenartig ausgestaltet, wobei der Flanscheinsatz 4 wiederum eine im Wesentlichen gezackte Außenkontur 15 aufweist. Die zugeordnete Innenkontur 16 ist wiederum gerade ausgestaltet. Auch hier ist es denkbar, dass die Innenkontur 16 gezackt ausgestaltet ist. Ferner ist es denkbar, dass an Stelle einer gezackten Kontur eine gewellte Kontur Anwendung findet.

Fig. 2 zeigt schließlich, dass der Flanscheinsatz 4 an seiner Oberseite eine wannenartige Aussparung 17 aufweist, in die der Halbleiter-Nacktchip 7 eingesetzt werden kann.

Die obigen gezackten bzw. gewellten Konturen sind besonders vorteilhaft, wenn ein Preßsitz der betreffenden Komponente erzeugt werden soll.

Interessant bei beiden in der Zeichnung dargestellten Ausführungsvarianten ist die Tatsache, dass die plattenartige Wärmesenke 10 eine Grundplatte 18 der Leiterplatte 1 bereitstellt, die hier und vorzugsweise eine Dicke von mehr als 0,5 mm aufweist. Die Grundplatte 18 besteht in einer bevorzugten Ausgestaltung aus Kupfer.

Die Aussparung 5 für den Flanscheinsatz 4 (Fig. 3) und/oder die Aussparung 12 für den flanschseitigen Wärmeleitabschnitt 11 der Wärmesenke 10 ist hier und vorzugsweise in der Grundplatte 18 vorgesehen. In besonders bevorzugter Ausgestaltung ist hier wie oben angesprochen ein Presssitz vorgesehen, so dass ein guter Wärmeübergang zwischen der Grundplatte 18 und dem flanschseitigen Wärmeleitabschnitt 11 gewährleistet ist. Bei der in Fig. 3 dargestellten und insoweit bevorzugten Ausführungsform ist der flanschseitige Wärmeleitabschnitt 11 durch die Grundplatte 19 gebildet, so dass der Flanscheinsatz 4 direkt in die Aussparung 5 in der Grundplatte 18 eingesetzt ist. Eine solche Grundplatte 18 kann ein oben angesprochenes Halbfertigteil sein, das erst nach dem Montageschritt mit der Leiterplatte 1 im Übrigen verbunden wird. Dabei finden die üblichen Pressprozesse Anwendung, in denen die einzelnen Lagen 2 der Leiterplatte 1 mit der vorzugsweise aus Kupfer bestehenden Grundplatte 18 verpresst werden.

In besonders bevorzugter Ausgestaltung ist es gemäß Fig. 4 so, dass der eingesetzte Flanscheinsatz 4 nicht über den plattenartigen, flanschseitigen Wärmeleitabschnitt 11, der hier die obige Grundplatte 18 bildet, übersteht. Dies ist bei dem obigen Verpressen der einzelnen Lagen 2, 2' der Leiterplatte 1 mit dem die Grundplatte 18 bereitstellenden Halbfertigteil vorteilhaft. So ist auch ein Verpressen derart möglich, dass nach dem Verpressen auf beiden Seiten der Grundplatte 18 mindestens eine Lage 2, 2' der Leiterplatte 1 angeordnet ist bzw. sind. Bei der in Fig. 4 dargestellten Leiterplatte 1 ist auch die oben angesprochene Kupferschicht 3,3' beidseitig der Grundplatte 18 vorgesehen.

Grundsätzlich kann es in diesem Zusammenhang vorgesehen sein, dass der Flanscheinsatz 4 zumindest einseitig bündig mit der Grundplatte 18 abschließt, was ebenfalls in Fig. 4 gezeigt ist.

Nach weiteren, unabhängigen Lehren werden die Leiterplatte 1 als solche und die Wärmesenke 10 als solche beansprucht. Auf alle Ausführungen, die geeignet sind die Leiterplatte 1 und die Wärmesenke 10 zu erläutern, darf verwiesen werden.

Mit den vorschlagsgemäßen Lehren läßt sich wie erläutert ein optimaler Kompromiß zwischen guter Wärmeableitung und geringer mechanischer Beanspruchung des Halbleiter-Nacktchips 7 erzielen.

Es darf noch darauf hingewiesen werden, dass die vorschlagsgemäße Leiterplatte 1 mit einer Mehrzahl von Flanscheinsätzen 4 ausgestattet werden kann, die vorzugsweise unterschiedliche Materialparameter insbesondere im Hinblick auf deren Wärmeausdehnungskoeffizienten aufweisen.

Denkbar ist auch, dass eine vorschlagsgemäße Wärmesenke 10 mehrere Flanscheinsätze 4 aufweist, auf die jeweils ein Halbleiter-Nacktchip 7 des jeweiligen Halbleiter-Bauteils applizierbar ist. Die auf der Wärmesenke 10 vorhandenen Halbleiter-Nacktchips 7 können untereinander elektrisch kontaktiert werden, so dass die Wärmesenke 10 als solche bereits ein elektrisches Funktionsmodul bereitstellt. Die Wärmesenke 10 kann so auf oder in eine übergeordnete Leiterplatte 1 eingesetzt werden.

Zu allen obigen Varianten darf klarstellend darauf hingewiesen werden, dass ein Flanscheinsatz 4 nicht notwendigerweise genau einen Halbleiter-Nacktchip 7 aufnimmt. Vielmehr ist es denkbar, dass ein Flanscheinsatz 4 mehrere solcher Halbleiter-Nacktchips 7 trägt.

## Patentansprüche

1. Verfahren zur Bestückung einer Leiterplatte (1), die mindestens eine ein- oder beidseitig kupferkaschierte oder mit Leiterbahnen versehene Lage (2) aufweist, wobei in einem Montageschritt mindestens ein starrer Flanscheinsatz (4) in eine zugeordnete Aussparung (5, 6) in der Leiterplatte (1) oder in einem Leiterplatten-Halbfertigteil (11, 18) eingesetzt wird, wobei der Flanscheinsatz (4) einer Wärmesenke (10) der Leiterplatte (1) zugeordnet ist und mit einem flanschseitigen Wärmeleitabschnitt (11) der Wärmesenke (10) in wärmeleitenden Kontakt gebracht wird und wobei der flanschseitige Wärmeleitabschnitt (11) der Wärmesenke (10) im Wesentlichen plattenartig ausgestaltet ist,
**dadurch gekennzeichnet,**
**dass** vor dem Montageschritt der flanschseitige Wärmeleitabschnitt (11) der Wärmesenke (10) im Presssitz in eine Aussparung (12) in der Leiterplatte (1) eingepresst wird und dass im Montageschritt der Flanscheinsatz (4) in eine Aussparung (6) in dem flanschseitigen Wärmeleitabschnitt (11) eingesetzt wird, oder, dass im Montageschritt der Flanscheinsatz (4) in eine Aussparung (6) in dem flanschseitigen Wärmeleitabschnitt (11) der Wärmesenke (10) eingesetzt wird und danach der flanschseitige Wärmeleitabschnitt (11) zusammen mit dem Flanscheinsatz (4) im Pressitz in die zugeordnete Aussparung (12) in der Leiterplatte (1) eingepresst wird und dass in einem nachfolgenden Applikationsschritt auf den eingesetzten Flanscheinsatz (4) mindestens ein Halbleiter-Nacktchip (7) eines Halbleiter-Bauteils appliziert wird.

2. Verfahren nach Anspruch 1, **dadurch gekennzeichnet, dass** das Leiterplatten-Halbfertigteil (11, 18) nach dem Montageschritt und vor dem Applikationsschritt mit der Leiterplatte (1) im Übrigen verbunden wird.

3. Verfahren nach Anspruch 1 oder 2, **dadurch gekennzeichnet, dass** der Wärmeausdehnungskoeffizient des Flanscheinsatzes (4) unterschiedlich zu dem Wärmeausdehnungskoeffizienten des flanschseitigen Wärmeleitabschnitts (11) ist, vorzugsweise, dass der Wärmeausdehnungskoeffizient des Flanscheinsatzes (4) kleiner als der Wärmeausdehnungskoeffizient des flanschseitigen Wärmeleitabschnitts (11) ist, weiter vorzugsweise, dass der Wärmeausdehnungskoeffizient des Flanscheinsatzes (4) weniger als 90% des Wärmeausdehnungskoeffizienten des flanschseitigen Wärmeleitabschnitts (11) beträgt.

4. Verfahren nach einem der vorhergehenden Ansprüche, **dadurch gekennzeichnet, dass** der Flanscheinsatz (4) einen Wärmeausdehnungskoeffizienten aufweist, dessen Abweichung vom Wärmeausdehnungskoeffizienten des applizierten Halbleiter-Nacktchips (7) weniger als 10 %, vorzugsweise weniger als 5 %, weiter vorzugsweise weniger als 2 %, beträgt.

5. Verfahren nach Anspruch 1 oder 2, **dadurch gekennzeichnet, dass** das Einsetzen des Flanscheinsatzes (4) und/oder des flanschseitigen Wärmeleitabschnitts (11) zur Erzeugung eines Presssitzes auf ein Einpressen des Flanscheinsatzes (4) und/oder des flanschseitigen Wärmeleitabschnitts (11) zurückgeht,

6. Leiterplatte mit mindestens einer ein- oder beidseitig kupferkaschierten oder mit Leiterbahnen versehenen Lage (2) und mit einer Wärmesenke (10) für die Ableitung der von mindestens einem Halbleiter-Bauteil (8) erzeugten Wärme, wobei die Wärmesenke (10) mindestens einen Wärmeleitabschnitt (11) mit einer Aussparung (6) und einen in die Aussparung (6) eingesetzten, starren Flanscheinsatz (4) aufweist, auf den mindestens ein Halbleiter-Nacktchip (7) eines Halbleiter-Bauteils (8) applizierbar ist, wobei der Wärmeausdehnungskoeffizient des Flanscheinsatzes (4) unterschiedlich zu dem Wärmeausdehnungskoeffizienten des zugeordneten flanschseitigen Wärmeleitabschnitts (11) ist, wobei der flanschseitige Wärmeleitabschnitt (11) der Wärmesenke (10) im Wesentlichen plattenartig ausgestaltet ist und wobei der Flanscheinsatz (4) in eine Aussparung (6) in dem flanschseitigen Wärmeleitabschnitt (11) eingesetzt ist,
**dadurch gekennzeichnet,**
**dass** der flanschseitige Wärmeleitabschnitt (11) im Presssitz in eine Aussparung (12) in der Leiterplatte (1) eingepresst ist, vorzugsweise, dass der Wärmeausdehnungskoeffizient des Flanscheinsatzes (4) kleiner als der Wärmeausdehnungskoeffizient des flanschseitigen Wärmeleitabschnitts (11) ist, vorzugsweise, dass der Wärmeausdehnungskoeffizient des Flanscheinsatzes (4) weniger als 90% des Wärmeausdehnungskoeffizienten des flanschseitigen Wärmeleitabschnitts (11) beträgt.

7. Leiterplatte nach Anspruch 6, **dadurch gekennzeichnet, dass** der Flanscheinsatz (4) im Presssitz in eine Aussparung (6) im flanschseitigen Wärmeleitabschnitt (11) der Wärmesenke (10) eingepresst ist.

8. Leiterplatte nach einem der Ansprüche 6 oder 7, **dadurch gekennzeichnet, dass** der flanschseitige Wärmeleitabschnitt (11) der Wärmesenke (10) und/oder der Flanscheinsatz (4) aus einem metallischen Material besteht bzw. bestehen.

9. Leiterplatte nach einem der Ansprüche 6 bis 8, **dadurch gekennzeichnet dass** der eingesetzte Flanscheinsatz (4) nicht über den plattenartigen, flanschseitigen Wärmeleitabschnitt (11) übersteht.

10. Leiterplatte nach einem der Ansprüche 6 bis 9, **dadurch gekennzeichnet, dass** der flanschseitige Wärmeleitabschnitt (11) eine im Wesentlichen gezackte oder gewellte Außenkontur (13) aufweist, und/oder, dass die dem flanschseitigen Wärmeleitabschnitt (11) zugeordnete Aussparung (12) in der Leiterplatte (1) eine im Wesentlichen gezackte oder gewellte Innenkontur (14) aufweist.

11. Leiterplatte nach einem der Ansprüche 6 bis 10, **dadurch gekennzeichnet, dass** die Wärmesenke (10) eine Grundplatte (18) der Leiterplatte (1) bereitstellt und dass die Aussparung (6) für den Flanscheinsatz (4) und/oder die Aussparung (12) für den flanschseitigen Wärmeleitabschnitt (11) der Wärmesenke (10) in der Grundplatte (18) vorgesehen ist bzw. sind, vorzugsweise, dass der flanschseitige Wärmeleitabschnitt (11) durch die Grundplatte (18) gebildet ist.

## Claims

1. Method for populating a circuit board (1), which has at least one layer (2) which is copper-clad or provided with conductor tracks on one or both sides, wherein, in an assembly step, at least one rigid flange insert (4) is inserted into an assigned clearance (5, 6) in the circuit board (1) or in a semifinished circuit board part (11, 18), wherein the flange insert (4) is assigned to a heat sink (10) of the circuit board (1) and is brought into heat-conducting contact with a flange-side heat-conducting portion (11) of the heat sink (10) and wherein the flange-side heat-conducting portion (11) of the heat sink (10) is designed substantially in the manner of a plate,
**characterized**
**in that**, before the assembly step, the flange-side heat-conducting portion (11) of the heat sink (10) is pressed into a clearance (12) in the circuit board (1) with a press fit and in that, in the assembly step, the flange insert (4) is inserted into a clearance (6) in the flange-side heat-conducting portion (11), or in that, in the assembly step, the flange insert (4) is inserted into a clearance (6) in the flange-side heat-conducting portion (11) of the heat sink (10) and, after that, the flange-side heat-conducting portion (11) is pressed together with the flange insert (4) into the assigned clearance (12) in the circuit board (1) with a press fit and in that, in a subsequent application step, at least one bare semiconductor chip (7) of a semiconductor component is applied to the inserted flange insert (4).

2. Method according to Claim 1, **characterized in that**, after the assembly step and before the application step, the semifinished circuit board part (11, 18) is otherwise connected to the circuit board (1),

3. Method according to Claim 1 or 2, **characterised in that** the coefficient of thermal expansion of the flange insert (4) is different from the coefficient of thermal expansion of the flange-side heat-conducting portion (11), preferably **in that** the coefficient of thermal expansion of the flange insert (4) is less than the coefficient of thermal expansion of the flange-side heat-conducting portion (11), more preferably **in that** the coefficient of thermal expansion of the flange insert (4) is less than 90% of the coefficient of thermal expansion of the flange-side heat-conducting portion (11).

4. Method according to one of the preceding claims, **characterized in that** the flange insert (4) has a coefficient of thermal expansion that deviates from the coefficient of thermal expansion of the applied bare semiconductor chip (7) by less than 10%, preferably less than 5%, more preferably less than 2%.

5. Method according to Claim 1 or 2, **characterized in that** the insertion of the flange insert (4) and/or of the flange-side heat-conducting portion (11) relies on pressing in of the flange insert (4) and/or of the flange-side heat-conducting portion (11) to produce a press fit.

6. Circuit board with at least one layer (2) which is copper-clad or provided with conductor tracks on one or both sides and with a heat sink (10) for the dissipation of the heat produced by at least one semiconductor component (8), wherein the heat sink (10) has at least one heat-conducting portion (11) with a clearance (6) and a rigid flange insert (4), which is inserted into the clearance (6) and to which at least one bare semiconductor chip (7) of a semiconductor component (8) can be applied, wherein the coefficient of thermal expansion of the flange insert (4) is different from the coefficient of thermal expansion of the assigned flange-side heat-conducting portion (11), wherein the flange-side heat-conducting portion (11) of the heat sink (10) is designed substantially in the manner of a plate and wherein the flange insert (4) is inserted into a clearance (6) in the flange-side heat-conducting portion (11),
**characterized**
**in that** the flange-side heat-conducting portion (11) is pressed into a clearance (12) in the circuit board (1) with a press fit, preferably in that the coefficient of thermal expansion of the flange insert (4) is less than the coefficient of thermal expansion of the flange-side heat-conducting portion (11), preferably in that the coefficient of thermal expansion of the flange insert (4) is less than 90% of the coefficient of thermal expansion of the flange-side heat-conducting portion (11).

7. Circuit board according to Claim 6, **characterized in that** the flange insert (4) is pressed into a clearance (6) in the flange-side heat-conducting portion (11) of the heat sink (10) with a press fit.

8. Circuit board according to either of Claims 6 and 7, **characterized in that** the flange-side heat-conducting portion (11) of the heat sink (10) and/or the flange insert (4) consists or consist of a metallic material.

9. Circuit board according to one of Claims 6 to 8, **characterized in that** the inserted flange insert (4) does not project beyond the plate-like, flange-side heat-conducting portion (11).

10. Circuit board according to one of Claims 6 to 9, **characterized in that** the flange-side heat-conducting portion (11) has a substantially jagged or corrugated outer contour (13), and/or **in that** the clearance (12) in the circuit board (1) that is assigned to the flange-side heat-conducting portion (11) has a substantially jagged or corrugated inner contour (14).

11. Circuit board according to one of Claims 6 to 10, **characterized in that** the heat sink (10) provides a base plate (18) of the circuit board (1) and **in that** the clearance (6) for the flange insert (4) and/or the clearance (12) for the flange-side heat-conducting portion (11) of the heat sink (10) is or are provided in the base plate (18), preferably **in that** the flange-side heat-conducting portion (11) is formed by the base plate (18).

## Revendications

1. Procédé pour garnir un circuit imprimé (1), qui possède au moins une couche (2) revêtue de cuivre d'un côté ou des deux côtés ou pourvue de pistes conductrices, au moins un insert formant bride (4) rigide étant, lors d'une étape de montage, introduit dans un évidement (5, 6) associé dans le circuit imprimé (1) ou dans une pièce semi-finie de circuit imprimé (11, 18), l'insert formant bride (4) étant associé à un dissipateur de chaleur (10) du circuit imprimé (1) et amené en contact thermoconducteur avec une portion conductrice de chaleur (11) côté bride du dissipateur de chaleur (10) et la portion conductrice de chaleur (11) côté bride du dissipateur de chaleur (10) étant sensiblement configurée en forme de plaque,
**caractérisé en ce**
**qu'**avant l'étape de montage de la portion conductrice de chaleur (11) côté bride, le dissipateur de chaleur (10) est enfoncé par ajustement serré dans un évidement (12) dans le circuit imprimé (1) et **en ce que** dans l'étape de montage, l'insert formant bride (4) est introduit dans un évidement (6) dans la portion conductrice de chaleur (11) côté bride,
ou **en ce que** dans l'étape de montage, l'insert formant bride (4) est introduit dans un évidement (6) dans la portion conductrice de chaleur (11) côté bride du dissipateur de chaleur (10) et la portion conductrice de chaleur (11) côté bride, conjointement avec l'insert formant bride (4), est ensuite enfoncée par ajustement serré dans l'évidement (12) associé dans le circuit imprimé (1) et **en ce que** dans une étape d'application suivante, au moins une puce nue en semiconducteur (7) d'un composant semiconducteur est appliqué sur l'insert formant bride (4) inséré.

2. Procédé selon la revendication 1, **caractérisé en ce que** la pièce semi-finie de circuit imprimé (11, 18) est par ailleurs reliée au circuit imprimé (1) après l'étape de montage et avant l'étape d'application.

3. Procédé selon la revendication 1 ou 2, **caractérisé en ce que** le coefficient de dilatation thermique de l'insert formant bride (4) est différent du coefficient de dilatation thermique de la portion conductrice de chaleur (11) côté bride, de préférence **en ce que** le coefficient de dilatation thermique de l'insert formant bride (4) est inférieur au coefficient de dilatation thermique de la portion conductrice de chaleur (11) côté bride, encore de préférence **en ce que** le coefficient de dilatation thermique de l'insert formant bride (4) est égal à moins de 90% du coefficient de dilatation thermique de la portion conductrice de chaleur (11) côté bride.

4. Procédé selon l'une des revendications précédentes, **caractérisé en ce que** l'insert formant bride (4) présente un coefficient de dilatation thermique dont l'écart par rapport au coefficient de dilatation thermique de la puce nue en semiconducteur (7) appliquée est inférieure à 10% de préférence inférieure à 5%, encore de préférence inférieure à 2%.

5. Procédé selon la revendication 1 ou 2, **caractérisé en ce que** l'introduction de l'insert formant bride (4) et/ou de la portion conductrice de chaleur (11) côté bride en vue de produire un ajustement serré renvoie à un enfoncement de l'insert formant bride (4) et/ou de la portion conductrice de chaleur (11) côté bride.

6. circuit imprimé comprenant au moins un couche (2) revêtue de cuivre d'un côté ou des deux côtés ou pourvue de pistes conductrices, et comprenant un dissipateur de chaleur (10) destiné à évacuer la chaleur produite par au moins un composant semiconducteur (8), le dissipateur de chaleur (10) possédant au moins une portion conductrice de chaleur (11) côté bride pourvue d'un évidement (6) et d'un insert formant bride (4) rigide introduit dans l'évidement (6), sur lequel peut être appliquée l'au moins une puce nue en semiconducteur (7) d'un composant semiconducteur (8), le coefficient de dilatation thermique de l'insert formant bride (4) étant différent du coefficient de dilatation thermique de la portion conductrice de chaleur (11) côté bride associée, la portion conductrice de chaleur (11) côté bride du dissipateur de chaleur (10) étant configurée sensiblement plane et l'insert formant bride (4) étant introduit dans un évidement (6) dans la portion conductrice de chaleur (11) côté bride,
**caractérisé en ce**
**que** la portion conductrice de chaleur (11) côté bride est enfoncée par ajustement serré dans un évidement (12) dans le circuit imprimé (1), de préférence **en ce que** le coefficient de dilatation thermique de l'insert formant bride (4) est inférieur au coefficient de dilatation thermique de la portion conductrice de chaleur (11) côté bride, de préférence **en ce que** le coefficient de dilatation thermique de l'insert formant bride (4) est égal à moins de 90% du coefficient de dilatation thermique de la portion conductrice de chaleur (11) côté bride.

7. Circuit imprimé selon la revendication 6, **caractérisé en ce que** l'insert formant bride (4) est enfoncé par ajustement serré dans un évidement (6) dans la portion conductrice de chaleur (11) côté bride du dissipateur de chaleur (10),

8. Circuit imprimé selon l'une des revendications 6 ou 7, **caractérisé en ce que** la portion conductrice de chaleur (11) côté bride du dissipateur de chaleur (10) et/ou l'insert formant bride (4) se composent d'un matériau métallique.

9. Circuit imprimé selon l'une des revendications 6 à 8, **caractérisé en ce que** l'insert formant bride (4) introduit ne dépasse pas au-dessus de la portion conductrice de chaleur (11) côté bride de type plaque.

10. Circuit imprimé selon l'une des revendications 6 à 9, **caractérisé en ce que** la portion conductrice de chaleur (11) côté bride possède un contour extérieur (13) sensiblement dentelé ou ondulé et/ou **en ce que** l'évidement (12) associé à la portion conductrice de chaleur (11) côté bride dans le circuit imprimé (1) possède un contour intérieur (14) sensiblement dentelé ou ondulé.

11. Circuit imprimé selon l'une des revendications 6 à 10, **caractérisé en ce que** le dissipateur de chaleur (10) fournit une platine de base (18) du circuit imprimé (1) et **en ce que** l'évidement (6) pour l'insert formant bride (4) et/ou l'évidement (12) pour la portion conductrice de chaleur (11) côté bride du dissipateur de chaleur (10) se trouve (nt) dans la platine de base (18), de préférence **en ce que** la portion conductrice de chaleur (11) côté bride est formée par la platine de base (18).
